# EUROPÄISCHE PATENTSCHRIFT

(11) **EP 1 266 454 B1**
(45) Veröffentlichungstag und Bekanntmachung des Hinweises auf die Patenterteilung: **22.10.2003**
(21) Anmeldenummer: 00906572.3
(22) Anmeldetag: 15.03.2000
(51) Int. Cl.: H03K 17/12

(54) **VERFAHREN ZUM BETRIEB EINER PARALLELANORDNUNG VON LEISTUNGSHALBLEITERSCHALTERN**
METHOD FOR OPERATING A PARALLEL ARRANGEMENT OF POWER SEMICONDUCTOR SWITCHES
PROCEDE POUR L'EXPLOITATION D'UN MONTAGE EN PARALLELE D'INTERRUPTEURS DE PUISSANCE A SEMI-CONDUCTEUR

(43) Veröffentlichungstag der Anmeldung: 18.12.2002
(73) Patentinhaber: CT-Concept Technologie AG, 2504 Biel (CH)
(72) Erfinder: THALHEIM, Jan, CH-8912 Obfelden (CH); RÜEDI, Heinz, CH-2533 Evilard (CH)
(74) Vertreter: Blum, Rudolf Emil Ernst
(86) Internationale Anmeldenummer: IB0000277
(87) Internationale Veröffentlichungsnummer: WO01069784

(56) Entgegenhaltungen:
- EP-A- 0 685 940
- FR-A- 2 270 635
- US-A- 4 616 142

## Beschreibung

Die Erfindung bezieht sich auf das Gebiet der Leistungselektronik. Sie betrifft ein Verfahren zum Betrieb einer Parallelschaltung von Leistungshalbleiterschaltern gemäss Oberbegriff der unabhängigen Ansprüche.

Ein derartiges Verfahren ist in dem U. S. Pat. No. 4,616,142 offenbart. Dort werden N parallele Leistungshalbleiterschalter sequentiell angesteuert, so dass jeder Leistungshalbleiterschalter im Mittel ein 1/N-tel des Gesamtstroms trägt. Nachteilig ist dabei einerseits, dass jeweils nur ein Leistungshalbleiterschalter leitfähig ist. Der zulässige Gesamtstrom ist daher durch die stationäre Stromtragfähigkeit des am wenigsten belastbaren Leistungshalbleiterschalters begrenzt und entsprechend gering. Andererseits erfolgt die Lastverteilung zwischen den Leistungshalbleiterschaltern gemäss einem fixen repetitiven Schaltschema, so dass momentane Belastungsunterschiede zwischen den Leistungshalbleiterschaltern akkumulieren und nicht ausgeglichen werden können.

In der EP 0 409 384 A2 wird ein Verfahren offenbart, bei dem stationäre Teilströme durch parallele Schalter wie z. B. Thyristoren oder GTOs ("gate turn-off thyristors") symmetrisiert werden, indem deren Einschaltzeiten individuell vor- oder rückverschoben werden. Die erforderlichen Zeitverschiebungen werden in Abhängigkeit der momentanen Teillastströme berechnet und auf einen darauffolgenden Gesamtstrompuls durch die Parallelschaltung angewendet. Zur Begrenzung des Stromanstiegs in den verzögert angeschalteten GTOs sind grosse Induktivitäten in Serie zu den GTOs angeordnet. Dadurch werden jedoch die Einschaltzeiten verlängert und die dynamischen Verluste erhöht.

In der EP 0 664 613 A2 werden transiente und stationäre Ströme durch parallel angeordnete IGBTs ("Insulated Gate Bipolar Transistor") symmetrisiert, indem einerseits die Ein- und Ausschaltzeitpunkte synchronisiert und andererseits die Höhe der Gate-Steuerpulse und damit die stationären Stromamplituden für jeden IGBT einzeln geregelt werden. Die Regelung erfolgt in Abhängigkeit einer gemessenen thermischen Belastung jedes IGBTs. In dieser Anordnung können zwar grosse serielle Induktivitäten vermieden werden. Gleichwohl ist durch Stromamplitudenregelung eine Angleichung der stationären thermischen Belastungen der IGBTs nur mit grossen Zeitkonstanten über viele Schaltzyklen und damit relativ ungenau möglich. Zudem ist das Verfahren nicht auf nicht amplitudenregelbare Leistungshalbleiterschalter anwendbar.

Es ist Aufgabe der Erfindung, ein verbessertes Verfahren zum Betrieb einer Parallelschaltung von Leistungshalbleiterschaltern anzugeben, bei dem auch für grosse Gesamtströme durch die Parallelschaltung eine thermische Überlastung einzelner Leistungshalbleiterschalter im stationären Zustand auf einfache Weise vermieden wird und das sowohl für durchschaltende ("latchend") als auch für amplitudenregelbare Leistungshalbleiterschalter geeignet ist.

In einem ersten Aspekt besteht die erfindungsgemässe Lösung darin, dass der Parallelschaltung ein übergeordnetes Steuersignal mit einem Primärmuster von Rahmenschaltpulsen für einen Gesamtstrom durch die Parallelschaltung vorgegeben wird, dass ein Sekundärmuster von Unterschaltpulsen für das individuelle Steuersignal mindestens eines Leistungshalbleiterschalters erzeugt wird, dass zur Entlastung des Leistungshalbleiterschalters in einem leitenden Zustand der Parallelschaltung zumindest zeitweilig während einer Anzahl Rahmenpulse im Primärmuster eine davon abweichende Anzahl Unterschaltpulse im Sekundärmuster gewählt wird, und dass zumindest zeitweilig während einzelner Rahmenschaltpulse mehrere Unterschaltpulse im Sekundärmuster erzeugt werden.

In einem zweiten Aspekt besteht die erfindungsgemässe Lösung darin, dass der Parallelschaltung ein übergeordnetes Steuersignal mit einem Primärmuster von Rahmenschaltpulsen für einen Gesamtstrom durch die Parallelschaltung vorgegeben wird, dass ein Sekundärmuster von Unterschaltpulsen für das individuelle Steuersignal mindestens eines Leistungshalbleiterschalters erzeugt wird, dass zur Entlastung des Leistungshalbleiterschalters in einem leitenden Zustand der Parallelschaltung zumindest zeitweilig während einer Anzahl Rahmenpulse im Primärmuster eine davon abweichende Anzahl Unterschaltpulse im Sekundärmuster gewählt wird, und dass mehrere Leistungshalbleiterschalter so angesteuert werden, dass ihre Unterschaltpulse einander jeweils zu einem Rahmenschaltpuls ergänzen.

In einem dritten Aspekt besteht die erfindungsgemässe Lösung darin, dass der Parallelschaltung ein übergeordnetes Steuersignal mit einem Primärmuster von Rahmenschaltpulsen für einen Gesamtstrom durch die Parallelschaltung vorgegeben wird, dass ein Sekundärmuster von Unterschaltpulsen für das individuelle Steuersignal mindestens eines Leistungshalbleiterschalters erzeugt wird, dass zur Entlastung des Leistungshalbleiterschalters in einem leitenden Zustand der Parallelschaltung zumindest zeitweilig während einer Anzahl Rahmenpulse im Primärmuster eine davon abweichende Anzahl Unterschaltpulse im Sekundärmuster gewählt wird, und dass zur Erzielung hoher Taktfrequenzen des Gesamtstroms ein Primärmuster mit N Rahmenschaltpulsen auf N Sekundärmuster mit jeweils genau einem Unterschaltpuls aufgeteilt wird und für aufeinanderfolgende Primärmuster eine zufällige Zuordnung der N Sekundärmuster zu N Leistungshalbleiterschaltern der Parallelschaltung vorgenommen wird.

Die Anzahl Unterschaltpulse pro Rahmenpuls kann also permamenent oder vorübergehend ungleich eins gewählt werden und kann insbesondere je nach Bedarf dynamisch verändert werden. Darüberhinaus werden im zweiten und dritten Aspekt durch die Komplementarität der betreffenden oder gegebenenfalls aller Sekundärmuster die Anschaltzeiten vorteilhaft auf die jeweils leitenden Schalter verteilt und dadurch ihre Zusatzlastströme begrenzt, ohne den Entlastungseffekt für die vorübergehend gesperrten oder weniger leitenden Schalter einzuschränken. Es wird also ein asynchroner Betrieb der parallelen Schalter zur Symmetrisierung ihrer thermischen Belastungen oder Teillastströme vorgeschlagen. Dabei erhalten einzelne Schalter mehr oder weniger Schaltpulse, als durch das Gesamtschaltmuster nach Massgabe des von der Parallelschaltung zu liefernden Laststroms vorgegeben sind. Die Pulszahlvariation ist mit durchschaltenden und amplitudensteuerbaren Leistungshalbleitern implementierbar. Durch die Puls-Asynchronizität ist im Gegensatz zu herkömmlichen Verfahren eine sehr schnelle Lastumverteilung zwischen den parallelen Schaltern möglich. Schädliche Überlastzüstände einzelner Leistungshalbleiterschalter können also sofort, insbesondere innerhalb eines Rahmenpulses, erkannt und korrigiert werden. Durch die Veränderung der Schaltpulszahl werden dann die gesamte Anschaltzeit und damit die statischen Verluste des betreffenden Elements gesenkt. Die resultierenden kurzzeitigen Zusatzlastströme für die übrigen Leistungshalbleiterschalter sind jedoch in der Regel völlig unschädlich. Insbesondere sind Leistungshalbleiter-Parallelschaltungen sowieso für transiente Übertröme beim Einund Ausschalten überdimensioniert. Daher sind kurzzeitige Überströme durch einige, gegebenenfalls kühlere Elemente auch im leitenden Zustand der Parallelschaltung problemlos tolerierbar.

In einem Ausführungsbeispiel werden zumindest zeitweilig während einzelner Rahmenschaltpulse im Sekundärmuster mehrere Unterschaltpulse erzeugt und/oder Unterschaltpulse ausgelassen. Das Sekundärmuster weist also nur während Rahmenschaltpulsen Unterschaltpulse auf. Durch Hinzufügen von Unterschaltpulsen kann nicht nur eine Überlastregelung durchgeführt, sondern auch die Stromanstiegszeit bei breiten Rahmenschaltpulsen ohne Verwendung zusätzlicher Induktivitäten begrenzt werden. Durch Weglassen von Unterschaltpulsen sind längerandauernde Überlastzustände korrigierbar; andererseits können auf diese Weise hochfrequente Lastströme mit verringerten Schaltverlusten erzeugt werden.

In einem anderen Ausführungsbeispiel wird während kurzer Rahmenpulse auf das Einfügen zusätzlicher Unterschaltpulse verzichtet und bei Bedarf lediglich eine Breite der Unterschaltpulse gegenüber einer Breite der Rahmenpulse verkürzt. Zur Begrenzung der dynamischen Verluste ist es nämlich sinnvoll, Unterschaltpulse nur dann hinzuzufügen, wenn die Breite des zugehörigen Rahmenpulses mindestens eine, bevorzugt zwei Grössenordnungen grösser ist als die Ein- oder Ausschalttransientenzeit eines einzelnen Leistungshalbleiterschalters. Durch die Kombination einer Pulsdichten- und Pulsbreitenmodulation des Sekundärmusters relativ zum Primärmuster ist eine besonders flexible, von der Rahmenpulslänge unabhängige Ansteuerung der Parallelschaltung realisierbar.

In zusätzlichen Ausführungsbeispielen wird die Anzahl Unterschaltpulse in Abhängigkeit einer thermischen Belastung und/oder einer Pulsbreitenmodulation des Primärmusters für einzelne oder simultan für alle Leistungshalbleiterschalter geregelt.

Weitere Ausführungen, Vorteile und Anwendungen der Erfindung ergeben sich aus den abhängigen Ansprüchen sowie aus der nun folgenden Beschreibung anhand der Figuren.

### KURZE BESCHREIBUNG DER ZEICHNUNGEN

- Fig. 1: zeigt schematisch eine Parallelschaltung mit beispielhaft 3 Leistungshalbleiterschaltern;
- Fig. 2: zeigt erfindungsgemässe Schaltmuster mit (a) hinzugefügten, (b) weggelassenen und (c) komplementär weggelassenen Unterschaltpulsen; und
- Fig. 3: zeigt für parallele IGBTs das dynamische Verhalten der Ausgleichsregelung bei Hinzufügung eines Unterschaltpulses im Vergleich zur Stromamplitudenmodulation gemäss Stand der Technik (gestrichelt).

In den Figuren sind gleiche Teile mit gleichen Bezugszeichen versehen.

### WEGE ZUR AUSFÜHRUNG DER ERFINDUNG

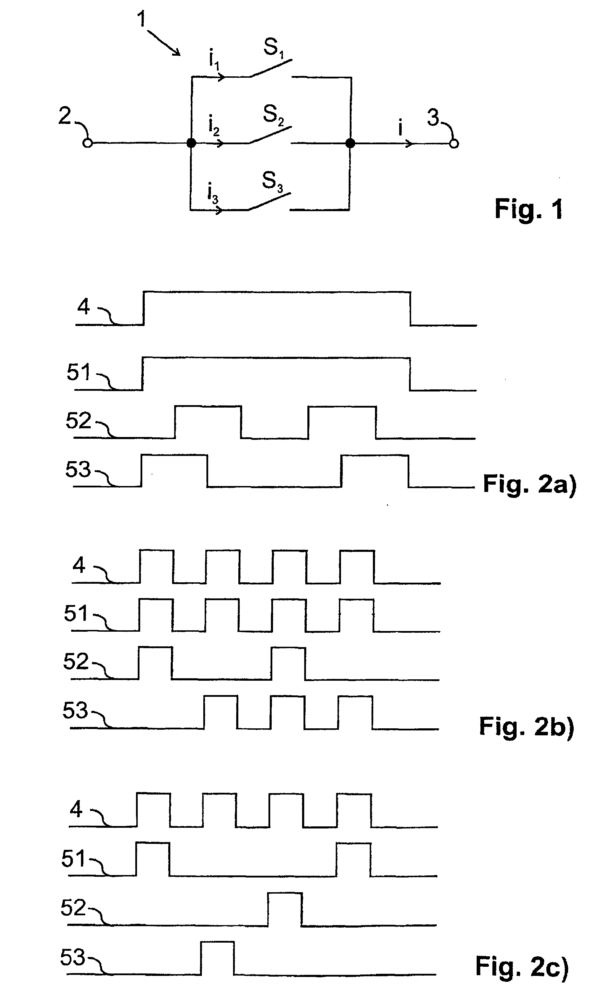

Fig. 1 zeigt eine Parallelschaltung 1 von N Leistungshalbleiterschaltern S₁, S₂, S₃, wobei beispielhaft N=3 gewählt ist. Die Parallelschaltung 1 weist einen Leistungsanschluss 2 zur Stromzuführung und einen Leistungsanschluss 3 zur Stromabführung an eine Last auf. Der Parallelschaltung 1 wird ein übergeordnetes Steuersignal mit einem Primärmuster 4 von Rahmenschaltpulsen für einen Gesamtstrom i durch die Parallelschaltung 1 vorgegeben. Die Leistungshalbleiterschalter S₁, S₂, S₃ sind durch individuelle Steuersignale ansteuerbar.
Fig. 2 zeigt Beispiele für erfindungsgemässe Sekundärmuster von Unterschaltpulsen, die den einzelnen, unmittelbar parallel geschalteten Leistungshalbleiterelementen S₁, S₂, S₃ eingeprägt werden. Es ist dabei erfindungswesentlich, dass die Anzahl Unterschaltpulse in mindestens einem Sekundärmuster 51, 52, 53 abweichend von der Anzahl Rahmenschaltpulse im Primärmuster 4 gewählt wird. Die Variation der Anzahl individueller Unterschaltpulse bezieht sich jeweils auf den leitfähigen Zustand der Parallelschaltung 1, der durch die Anwesenheit eines den Gesamtlaststrom steuernden Rahmenschaltpulses charakterisiert ist.

Die Sekundärmuster 51, 52, 53 können in folgenden, nicht mehr dargestellten Zeitabschnitten des Primärmusters 4 wieder verändert werden, z. B. um Spitzenlasten an wechselnden Leistungshalbleiterschaltern S₁, S₃, S₃ aufzufangen. Natürlich können die Sekundärmuster 51, 52, 53 zwischenzeitlich wieder an das Primärmuster 4 angeglichene Pulszahlen aufweisen.

Fig. 2 a) stellt eine Momentaufnahme dar, bei welcher während eines Rahmenpulses jeweils zwei kürzere, zeitlich versetzte Ünterschaltpulse an den Schaltern S₂ und S₃ angelegt werden. Die Anzahl, Breite und der zeitliche Versatz der Unterschaltpulse können in einem weiten Bereich variiert werden. Dabei ist zu beachten, dass die Gesamtstromtragfähigkeit der Parallelschaltung 1 im leitenden Zustand nicht über Gebühr eingeschränkt wird, d. h. Überlastströme an einzelnen Schaltern S₁, S₂, S₃ zeitlich und amplitudenmässig innerhalb des sicheren Arbeitsbereichs (SOA) gehalten werden und zugleich für einzelne oder mehrere Leistungshalbleiterschalter S₁, S₂, S₃ der gewünschte Entlastungseffekt erzielt wird. Insbesondere können für mindestens zwei Schalter S₂, S₃ die Unterschaltpulse so gewählt werden, dass sie einander nicht wesentlich überlappen und jeweils zu einem Rahmenschaltpuls ergänzen.

Mit Vorteil werden während der Einschalttransienten des Rahmenschaltpulses eine Mehrzahl der Schalter S₁, S₂, S₃ mit Unterschaltpulsen angesteuert, d. h. in einen leitfähigen Zustand geschaltet, um diejenigen transienten Überströme zu begrenzen, die typischerweise durch das Ausräumverhalten von in Serie angeordneten Freilaufdioden entstehen.

Durch das erfindungsgemässe Verfahren wird die gesamte Anschaltzeit der Sekundärmuster 51, 52, 53 gegenüber dem Primärmuster 4 verkürzt. Die Verkürzung ist in Abhängigkeit von der Anzahl paralleler Schalter S₁, S₂, S₃, dem geforderten Laststrom i und der gewünschten thermischen Entlastung an den Schaltern S₁, S₂, S₃ zu wählen. Bei Parallelschaltungen 1 in Wechselrichtern kann die Reduktion der mittleren Verlustleistung beispielsweise, mindestens 5%, bevorzugt mindestens 20%, besonders bevorzugt mindestens 50% betragen.

Fig. 2 b) zeigt ein Beispiel für die. Auslassung von Unterschaltpulsen an den Schaltern S₂ und S₃ relativ zum Primärmuster 4. Diese Methode ist besonders bei kurzen Rahmenschaltpulsen von Nutzen, die z. B. bei der Pulsbreitenmodulation von Sinuswellen in der Nähe von Nullstellen auftreten. Unterschreitet die Breite der Rahmenschaltpulse eine kritische Zeitdauer, z. B. das 100-fache bis 10-fache einer Ein- oder Ausschalttransientenzeit der Leistungshalbleiterschalter S₁, S₂, S₃, wird nämlich der Nutzen durch Einfügen von Unterschalpulsen durch die Erhöhung der dynamischen Verluste zunichte gemacht. Einzelne Schalter S₁, S₂, S₃ der Parallelschaltung 1 werden daher besser durch Weglassen von Unterschaltpulsen entlastet. Gegebenenfalls kann zusätzlich die Breite der Unterschaltpulse gegenüber einer Breite der Rahmenschaltpulse verkürzt werden.

Fig. 2 c) zeigt ein Beispiel, bei dem die Schalter S₁, S₂, S₃ durch Weglassen von Unterschaltpulsen mit Sekundärmustern 51, 52, 53 angesteuert werden, die einander zum Primärmuster 4 ergänzen. Dieses Verfahren ist besonders für die Erzeugung hochfrequenter Ströme i z. B. zum Betrieb leistungsstarker Sendeanlagen oder für induktives Erwärmen oder Schweissen geeignet. Die einzelnen Schalter S₁, S₂, S₃ können entsprechend langsamer getaktet werden. Zudem werden die Gesamt-Schaltverluste reduziert. Beispielsweise bei IGBTs nehmen die Ausschaltverluste durch kuzzeitige Überstrombelastung gegenüber einer Normalstrombelastung nur noch unwesentlich zu. Es ist also günstiger, jeweils einen IGBT S₁; S₂; S₃ bei kurzer Überlast als alle S₁, S₂, S₃ bei Normallast zu betreiben.

Die Zuordnung der Sekundärmuster 51, 52, 53 zu den N=3 Leistungshalbleiterschaltern S₁, S₂, S₃ kann fest vorgegeben sein. Sie kann aber auch nach einem oder mehreren Zyklen von N=3 Rahmenschaltpulsen gemäss einem regelmässigen Schema variiert werden oder aber zufällig, insbesondere statistisch gleichverteilt, erfolgen. Durch eine zufallsbedingte Zuordnung können zufällig auftretende thermische Belastungsschwankungen zwischen den Schaltern S₁, S₂, S₃ am besten ausgeglichen werden.

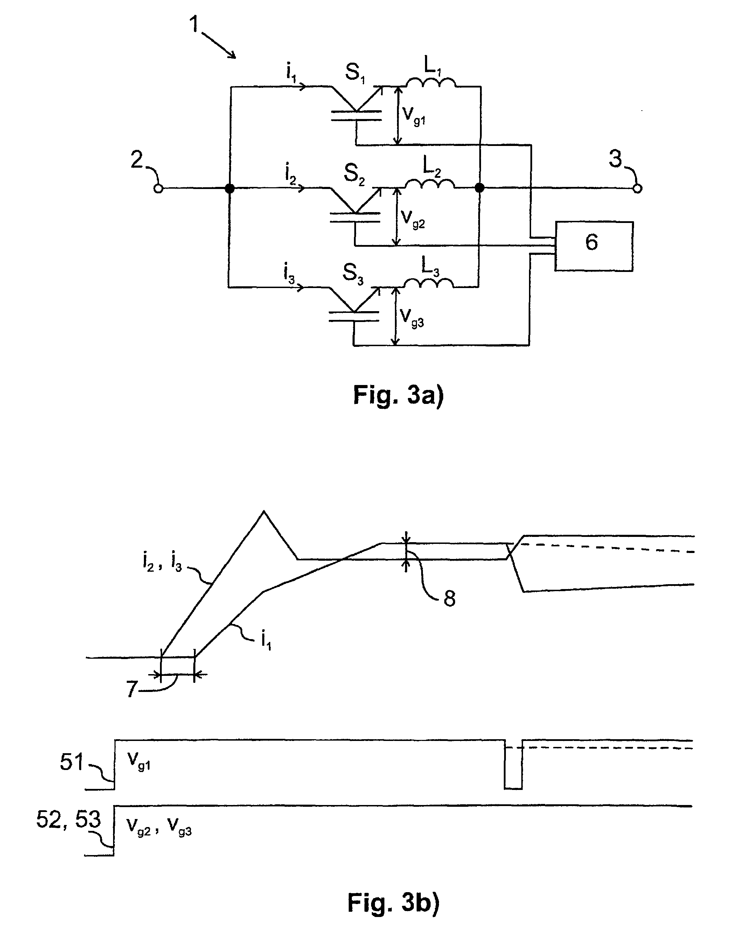

Fig. 3 zeigt das dynamische Verhalten der Teillastströme i₁, i₂, i₃ im Falle von drei parallelen IGBT-Schaltern S₁, S₂, S₃ mit jeweils seriellen Induktivitäten L₁, L₂, L₃. Im Beispiel bewirkt eine Einschaltverzögerung 7 des IGBT S₁, z.B. verursacht durch unterschiedliche Induktivitäten L₁, L₂, L₃ oder ungleiche interne Parameter der IGBTs S₁, S₂, S₃, einen asymmetrischen Stromanstieg i₁ gegenüber dem regulären Verlauf der Ströme i₂, i₃. Zudem verursacht das Zeitintegral der an der Induktivität L₁ anliegenden Spannung eine zu umgekehrt proportionale Überhöhung 8 des stationären Stromwerts i₁.

Gemäss Stand der Technik wird einerseits die Stromüberhöhung 8 dadurch begrenzt, dass die Induktivitäten L₁, L₂, L₃ sehr gross gewählt werden, z. B. 10 µH im Vergleich zu IGBT-internen 50 nH. Grosse Induktivitäten L₁, L₂, L₃ begrenzen aber die Schaltgeschwindigkeit, weil zu hohe Induktionsspannungen, die proportional zum Stromgradienten sind, nicht toleriert werden können. Andererseits wird im Stand der Technik (EP 0 664 613 A2) die Höhe der Gatespannung v_{g1} modifiziert, um die Stromamplitude i₁ anzupassen. Gemäss gestrichelter Darstellung in Fig. 3 b) bewirkt eine 10%-ige Verringerung der Gatespannung v_{g1} nur eine unmerkliche Absenkung der Stromamplitude i₁. Eine Angleichung der Ströme i₁, i₂, i₃ ist daher nur mit langsamen Zeitkonstanten über viele Rahmenschaltpulse möglich.

Im Gegensatz hierzu wird durch erfindungsgemässes Einfügen eines Unterschaltpulses an der Gatespannung v_{g1} des IGBT S₁ der Strom i₁ fast instantan und insbesondere noch im gleichen Rahmenschaltpuls 4 abgesenkt, so dass die Mittelwerte der Ströme i₁, i₂ und i₃ über den Rahmenschaltpuls 4 ausgeglichen werden. Im Beispiel nach Fig. 3 b) ist ein Amplitudenverhältnis des Gatespannungs-Unterschaltpulses von 20 gewählt. Zusätzlich zum Amplitudenverhältnis kann die Breite des Unterschaltpulses so angepasst werden, dass durch die Unterschaltpulse eine stationäre Teillaststromamplitude i₁ durch den Leistungshalbleiterschalter S₁ um mindestens einen Faktor zwei variiert wird. Im Extremfall, insbesondere bei nicht amplitudenmodulierbaren Leistungshalbleiterschaltern S₁, S₂, S₃, wird durch die Unterschaltpulse zwischen einem leitenden und einem im wesentlichen nicht leitfähigen Zustand hin- und hergeschaltet.

Überlastzustände an einzelnen Schaltern S₁, S₂, S₃ können also viel schneller und auch präziser korrigiert werden als bisher. Das Verfahren ist damit auch bei höheren Rahmenschaltpulsfrequenzen als bisher anwendbar. Der Hauptvorteil des Verfahrens besteht darin, dass die Induktivitäten L₁, L₂, L₃ nicht mehr für die Begrenzung der stationären Überströme benötigt werden und somit kleiner gewählt werden können. Darüberhinaus ist die erfindungsgemässe Regelung der Anzahl Unterschaltpulse mit anderen Verfahren zur dynamischen Symmetrisierung des transienten Ein- und Ausschaltverhaltens, z. B. gemäss der EP 0 664 613 A2, kompatibel. In diesem Fall können serielle Induktivitäten L₁, L₂, L₃ weiter reduziert oder ganz weggelassen werden. Dadurch ist, besonders für IGBTs, ein sehr schnelles Schalten mit sehr geringen dynamischen Verlusten bei zugleich hoher Symmetrie der stationären Belastungen realisierbar.

Eine speziell vorteilhafte Ausführungsform der Erfindung betrifft eine aktive Regelung 6 der Anzahl von Unterschaltpulsen mindestens eines Sekundärmusters 51, 52, 53 in Abhängigkeit einer Belastung des zugehörigen Leistungshalbleiterschalters S₁, S₂, S₃ der Parallelschaltung 1. Gegebenenfalls hängt die Regelung 6 auch von einer Pulsbreitenmodulation der Rahmenschaltpulse im Primärmuster 4 ab. Insbesondere wird eine gesamte Anschaltzeit des Sekundärmusters 51, 52, 53 proportional zur Belastung des zugehörigen Leistungshalbleiterschalters S₁, S₂, S₃ verringert. Die Verkürzung der Anschaltzeit wird durch einen oder mehrere zusätzliche oder weggelassene Unterschaltpulse bewirkt. Die Regelung 6 kann im gleichen oder in folgenden Rahmenschaltpulsen eingreifen, solange sie vergleichbar schnell ist wie die thermische Zeitkonstante des betreffenden Schalters S₁, S₂, S₃.

Im Detail wird ein Belastungsistwert des Leistungshalbleiterschalters S₁, S₂, S₃ gemessen und bei Überschreitung eines Belastungssollwerts eine Anzahl Unterschaltpulse pro Rahmenschaltpuls erhöht oder erniedrigt. Der Belastungsist- und sollwert kann eine Temperatur des Leistungshalbleiterschalters S₁, S₂, S₃, ein Kollektor- oder Kathodenstrom durch den Leistungshalbleiterschalter S₁, S₂, S₃ oder ein Kurzzeitmittelwert dieser Grössen sein. Die Temperatur kann am Gehäuse, Kühler oder Leistungshalbleiter selber gemessen werden. Die Regelung 6 kann in an sich bekannter Weise mit einer Hysterese oder mit Verzögerungszeiten zur Begrenzung der Unterschaltfrequenzen versehen werden. Mit Vorteil werden alle Schalter S₁, S_{2,} S₃ der Parallelschaltung 1 simultan durch eine gemeinsame Ausgleichsregelung 6 thermisch symmetrisiert.

Die erfindungsgemäss gesteuerte Parallelschaltung 1 kann Bestandteil eines Schaltermoduls, insbesondere eines Halbbrückenzweigs eines Wechselrichters, für Traktion, Hochspannungsgleichstromübertragung, Radiosender, induktives Erwärmen oder induktives Schweissen sein. Als Leistungshalbleiterschalter S₁, S₂, S₃ sind BJTs ("bipolar junction transistors"), IGBTs, MOSPETs, Thyristoren, GTOs, insbesondere solche mit integriertem Treiber, MCTs ("MOSFETcontrolled thyristors") oder verwandte Bauelemente oder Kombinationen derartiger Bauelemente geeignet. Das Verfahren ist insbesondere auch für Parallelschaltungen von Leistungshalbleiterschaltern geeignet, die nicht oder schlecht amplitudenregelbare Leistungsausgänge besitzen.

## Patentansprüche

1. Verfahren zum Betrieb einer Parallelschaltung (1) von Leistungshalbleiterschaltern (S₁, S₂, S₃), wobei die Parallelschaltung (1) einen Leistungsanschluss (2) zur Stromzuführung und einen Leistungsanschluss (3) zur Stromabführung an eine Last aufweist, wobei der Parallelschaltung (1) ein übergeordnetes Steuersignal mit einem Primärmuster (4) von Rahmenschaltpulsen für einen Gesamtstrom (i) durch die Parallelschaltung (1) vorgegeben wird, wobei ferner die Leistungshalbleiterschalter (S₁, S₂, S₃) durch individuelle Steuersignale ansteuerbar sind, wobei
a) mindestens ein Sekundärmuster (51, 52, 53) von Unterschaltpulsen für das individuelle Steuersignal mindestens eines Leistungshalbleiterschalters (S₁, S₂, S₃) erzeugt wird und
b) zur Entlastung des Leistungshalbleiterschalters (S₁, S₂, S₃) in einem leitenden Zustand der Parallelschaltung (1) zumindest zeitweilig während einer Anzahl Rahmenschaltpulse im Primärmuster (4) eine davon abweichende Anzahl Unterschaltpulse im Sekundärmuster (51, 52, 53) gewählt wird,
**dadurch gekennzeichnet, dass**
c) zumindest zeitweilig während einzelner Rahmenschaltpulse mehrere Unterschaltpulse im Sekundärmuster (51, 52, 53) erzeugt werden (Fig 2a).

2. Verfahren nach Anspruch 1, **dadurch gekennzeichnet, dass** zumindest zeitweilig während einzelner Rahmenschaltpulse Unterschaltpulse im Sekundärmuster (51, 52, 53) ausgelassen werden.

3. Verfahren nach einem der vorangehenden Ansprüche, **dadurch gekennzeichnet, dass**
a) während kurzer Rahmenschaltpulse, deren Pulsbreite maximal das 100-fache einer transienten Schaltzeit des Leistungshalbleiterschalters (S₁, S₂, S₃) beträgt, die Anzahl Unterschaltpulse gegenüber der Anzahl Rahmenschaltpulse nicht erhöht wird und
b) insbesondere dass eine Breite der Unterschaltpulse gegenüber einer Breite der Rahmenschaltpulse verkürzt wird.

4. Verfahren zum Betrieb einer Parallelschaltung (1) von Leistungshalbleiterschaltern (S₁, S₂, S₃), insbesondere nach einem der vorangehenden Ansprüche, wobei die Parallelschaltung (1) einen Leistungsanschluss (2) zur Stromzuführung und einen Leistungsanschluss (3) zur Stromabführung an eine Last aufweist, wobei der Parallelschaltung (1) ein übergeordnetes Steuersignal mit einem Primärmuster (4) von Rahmenschaltpulsen für einen Gesamtstrom (i) durch die Parallelschaltung (1) vorgegeben wird, wobei ferner die Leistungshalbleiterschalter (S₁, S₂, S₃) durch individuelle Steuersignale ansteuerbar sind, wobei
a) mindestens ein Sekundärmuster (51, 52, 53) von Unterschaltpulsen für das individuelle Steuersignal mindestens eines Leistungshalbleiterschalters (S₁, S₂, S₃) erzeugt wird und
b) zur Entlastung des Leistungshalbleiterschalters (S₁, S₂, S₃) in einem leitenden Zustand der Parallelschaltung (1) zumindest zeitweilig während einer Anzahl Rahmenschaltpulse im Primärmuster (4) eine davon abweichende Anzahl Unterschaltpulse im Sekundärmuster (51, 52. 53) gewählt wird,
**dadurch gekennzeichnet, dass**
c) mindestens zwei Leistungshalbleiterschalter (S₁, S₂, S₃) mit Unterschaltpulsen angesteuert werden, die einander jeweils zu einem Rahmenschaltpuls ergänzen (Fig. 2a).

5. Verfahren nach einem der vorangehenden Ansprüche, **dadurch gekennzeichnet, dass** mindestens zwei Leistungshalbleiterschalter (S₁, S₂, S₃) mit Sekundärmustern (51, 52, 53) angesteuert werden, die einander zum Primärmuster (4) ergänzen.

6. Verfahren nach einem der vorangehenden Ansprüche, **dadurch gekennzeichnet, dass**
a) eine stationäre Teillaststromamplitude (i₁, i₂, i₃) durch den Leistungshalbleiterschalter (S₁, S₂, S₃) durch die Unterschaltpulse um mindestens einen Faktor zwei variiert wird und/oder
b) der Leistungshalbleiterschalter (S₁, S₂, S₃) durch die Unterschaltpulse zwischen einem leitenden und einem im wesentlichen nicht leitfähigen Zustand hin- und hergeschaltet wird.

7. Verfahren nach einem der vorangehenden Ansprüche, **dadurch gekennzeichnet, dass**
a) eine Anzahl von Unterschaltpulsen des Sekundärmusters (51, 52, 53) in Abhängigkeit einer Belastung des zugehörigen Leistungshalbleiterschalters (S₁, S₂, S₃) der Parallelschaltung (1) geregelt wird und/oder
b) eine Anzahl von Unterschaltpulsen des Sekundärmusters (51, 52, 53) in Abhängigkeit einer Pulsbreite von Rahmenschaltpulsen geregelt wird und
c) insbesondere dass eine gesamte Anschaltzeit des Sekundärmusters (51, 52, 53) proportional zur Belastung des zugehörigen Leistungshalbleiterschalters (S₁, S₂, S₃) verringert wird.

8. Verfahren nach Anspruch 7, **dadurch gekennzeichnet, dass**
a) ein Belastungsistwert des Leistungshalbleiterschalters (S₁, S₂, S₃) gemessen und bei Überschreitung eines Belastungssollwerts eine Anzahl Unterschaltpulse pro Rahmenschaltpuls erhöht oder erniedrigt wird und
b) insbesondere dass der Belastungsist- und sollwert eine Temperatur des Leistungshalbleiterschalters (S₁, S₂, S₃), ein Kollektor- oder Kathodenstrom durch den Leistungshalbleiterschalter (S₁, S₂, S₃) oder ein Kurzzeitmittelwert dieser Grössen ist.

9. Verfahren nach einem der Ansprüche 7-8, **dadurch gekennzeichnet, dass** zur thermischen Symmetrisierung der Parallelschaltung (1) eine Anzahl der Unterschaltpulse aller Sekundärmuster (51, 52, 53) durch eine Ausgleichsregelung (6) simultan geregelt wird.

10. Verfahren zum Betrieb einer Parallelschaltung (1) von Leistungshalbleiterschaltern (S₁, S₂, S₃), wobei die Parallelschaltung (1) einen Leistungsanschluss (2) zur Stromzuführung und einen Leistungsanschluss (3) zur Stromabführung an eine Last aufweist, wobei der Parallelschaltung (1) ein übergeordnetes Steuersignal mit einem Primärmuster (4) von Rahmenschaltpulsen für einen Gesamtstrom (i) durch die Parallelschaltung (1) vorgegeben wird, wobei ferner die Leistungshalbleiterschalter (S₁, S₂, S₃) durch individuelle Steuersignale ansteuerbar sind, wobei
a) mindestens ein Sekundärmuster (51, 52, 53) von Unterschaltpulsen für das individuelle Steuersignal mindestens eines Leistungshalbleiterschalters (S₁, S₂, S₃) erzeugt wird,
b) zur Entlastung des Leistungshalbleiterschalters (S₁, S₂, S₃) in einem leitenden Zustand der Parallelschaltung (1) zumindest zeitweilig während einer Anzahl Rahmenschaltpulse im Primärmuster (4) eine davon abweichende Anzahl Unterschaltpulse im Sekundärmuster (51, 52, 53) gewählt wird, und
c) zur Erzielung hoher Taktfrequenzen des Gesamtstroms (i) ein Primärmuster mit N Rahmenschaltpulsen auf N Sekundärmuster (51, 52, 53) mit jeweils genau einem Unterschaltpuls aufgeteilt wird,
**dadurch gekennzeichnet, dass**
d) für aufeinanderfolgende Primärmuster (4) eine zufällige Zuordnung der N Sekundärmuster (51, 52, 53) zu N Leistungshalbleiterschaltern (S₁, S₂, S₃) der Parallelschaltung (1) vorgenommen wird.

11. Verfahren nach Anspruch 10, **dadurch gekennzeichnet, dass** für aufeinanderfolgende Primärmuster (4) eine statistisch gleichverteilte Zuordnung der N Sekundärmuster (51, 52, 53) zu N Leistungshalbleiterschaltern (S₁, S₂, S₃) der Parallelschaltung (1) vorgenommen wird.

12. Verfahren nach einem der vorangehenden Ansprüche, **dadurch gekennzeichnet, dass**
a) die Parallelschaltung (1) Bestandteil eines Schaltermoduls, insbesondere eines Halbbrückenzweigs eines Wechselrichters, für Traktion, Hochspannungsgleichstromübertragung, Radiosender, induktives Erwärmen oder induktives Schweissen ist und/oder
b) die Leistungshalbleiterschalter (S₁, S₂, S₃) BJTs, IGBTs, MOSFETs, Thyristoren, GTOs, MCTs oder Kombinationen solcher Bauelemente sind und insbesondere nicht oder schlecht amplitudenregelbare Leistungsausgänge aufweisen.

## Claims

1. Method for operating a parallel circuit (1) of semiconductor power switches (S₁, S₂, S₃), wherein the parallel circuit (1) comprises a power terminal (2) to feed current to and a power terminal (3) to collect current from a load, wherein a master control signal with a primary pattern (4) of frame switching pulses is provided to the parallel circuit (1) for a total current (i) through the parallel circuit (1), wherein further the semiconductor power switches (S₁, S₂, S₃) are controllable with individual control signals, wherein
a) at least one secondary pattern (51, 52, 53) of slave switching pulses is generated for the individual control signal of at least one semiconductor power switch (S₁, S₂, S₃),
b) in a conducting state of the parallel circuit (1), at least temporarily, during a number of frame switching pulses in the primary pattern (4), a different number of slave switching pulses in the secondary pattern (51, 52, 53) is used for taking load from the semiconductor power switch (S₁, S₂, S₃),
**characterized in that**
c) at least temporarily during individual frame switching pulses, several slave switching pulses in the secondary pattern (51, 52, 53) are generated (Fig. 2a).

2. Method of claim 1, **characterized in that** at least temporarily during individual frame switching pulses, slave switching pulses in the secondary pattern (51, 52, 53) are omitted.

3. Method of any of the preceding claims, **characterized in that**
a) the number of slave switching pulses are not increased, compared to the number of frame switching pulses, during short frame switching pulses the pulse width of which is maximally 100 times longer than a transient switching time of the semiconductor power switch (S₁, S₂, S₃) and
b) in particular that a width of the slave switching pulses, compared to a width of the frame switching pulses, is shorted.

4. Method for operating a parallel circuit (1) of semiconductor power switches (S₁, S₂, S₃), in particular of any of the preceding claims, wherein the parallel circuit (1) comprises a power terminal (2) to feed current to and a power terminal (3) to collect current from a load, wherein a master control signal with a primary pattern (4) of frame switching pulses is provided to the parallel circuit (1) for a total current (i) through the parallel circuit (1), wherein further the semiconductor power switches (S₁, S₂, S₃) are controllable with individual control signals, wherein
a) at least one secondary pattern (51, 52, 53) of slave switching pulses is generated for the individual control signal of at least one semiconductor power switch (S₁, S₂, S₃),
b) in a conducting state of the parallel circuit (1), at least temporarily, during a number of frame switching pulses in the primary pattern (4), a different number of slave switching pulses in the secondary pattern (51, 52, 53) is used for taking load from the semiconductor power switch (S₁, S₂, S₃),
**characterized in that**
c) at least two semiconductor power switches (S₁, S₂, S₃) are controlled with slave switching pulses that correspond, when combined, to a frame switching pulse (Fig. 2a).

5. Method of any of the preceding claims, **characterized in that** at least two semiconductor power switches (S₁, S₂, S₃) are controlled with secondary patterns (51, 52, 53) that correspond, when combined, to the primary pattern (4).

6. Method of any of the preceding claims, **characterized in that**
a) a stationary partial load current amplitude (i₁, i₂, i₃) through the semiconductor power switch (S₁, S₂, S₃) is varied by the slave switching pulses by at least a factor two and/or
b) the semiconductor power switch (S₁, S₂, S₃) is switched back and forth by the slave switching pulses between a conducting and substantially non- conducting state.

7. Method of any of the preceding claims, **characterized in that**
a) a number of slave switching pulses of the secondary pattern (51, 52, 53) is controlled in response to a load of the corresponding semiconductor power switch (S₁, S₂, S₃) of the parallel circuit (1) and/or
b) a number of slave switching pulses in the secondary pattern (51, 52, 53) is controlled in response to a pulse width of frame switching pulses and
c) in particular that a total turned-on time of the secondary pattern (51, 52, 53) is reduced proportionally to the load of the corresponding semiconductor power switch (S₁, S₂, S₃).

8. Method of claim 7, **characterized in that**
a) an actual load value of the semiconductor power switch (S₁, S₂, S₃) is measured and a number of slave switching pulses per frame switching pulse is increased or decreased if the actual load value is exceeding a desired load value and
b) in particular the actual load value and the desired load value are a temperature of the semiconductor power switch (S₁, S₂, S₃), a collector current or cathode current that runs through the semiconductor power switch (S₁, S₂, S₃) or a short-time average value of these quantities.

9. Method of any of the claims 7-8, **characterized in that** a number of the slave switching pulses of all secondary patterns (51, 52, 53) is concurrently regulated by a compensation control (6) for thermal symmetrisation of the parallel circuit (1).

10. Method for operating a parallel circuit (1) of semiconductor power switches (S₁, S₂, S₃), wherein the parallel circuit (1) comprises a power terminal (2) to feed current to and a power terminal (3) to collect current from a load, wherein a master control signal with a primary pattern (4) of frame switching pulses is provided to the parallel circuit (1) for a total current (i) through the parallel circuit (1), wherein further the semiconductor power switches (S₁, S₂, S₃) are controllable with individual control signals, wherein
a) at least one secondary pattern (51, 52, 53) of slave switching pulses is generated for the individual control signal of at least one semiconductor power switch (S₁, S₂, S₃),
b) in a conducting state of the parallel circuit (1), at least temporarily, during a number of frame switching pulses in the primary pattern (4), a different number of slave switching pulses in the secondary pattern (51, 52, 53) is used for taking load from the semiconductor power switch (S₁, S₂, S₃), and
c) a primary pattern with N frame switching pulses is divided into N secondary patterns (51, 52, 53), each with exactly one slave switching pulse, for achieving high clock rates of the total current (i),
**characterized in that**
d) a random attribution of the N secondary patterns (51, 52, 53) is made to the N semiconductor power switches (S₁, S₂, S₃) of the parallel circuit (1) for consecutive primary patterns (4).

11. Method of claim 10, **characterized in that**, for consecutive primary patterns (4), a statistically uniform attribution of the N secondary patterns (51, 52, 53) is made to the N semiconductor power switches (S₁, S₂, S₃) of the parallel circuit (1).

12. Method of any of the preceding claims, **characterized in that**
a) the parallel circuit (1) is part of a switch module, in particular for a half bridge arm of an inverter for traction, high voltage DC transmission, radio transmitters, inductive heating or inductive welding and/or
b) the semiconductor power switches (S₁, S₂, S₃) are BJTs, IGBTs, MOSFETs, thyristors, GTOs, MCTs or combinations of such devices and in particular they have power outlets the amplitude of which is impossible or difficult to control.

## Revendications

1. Procédé d'exploitation d'un montage en parallèle (1) d'interrupteurs de puissance à semi-conducteur (S1, S2, S3), le montage en parallèle (1) présentant une connexion de puissance (2) pour une amenée du courant et une connexion de puissance (3) pour une sortie de courant sur une résistance de charge, le montage en parallèle (1) étant pourvu d'un signal de commande principal avec un premier modèle (4) d'impulsions de commande de cadre pour un courant total (i) à travers le montage en parallèle (1), les interrupteurs de puissance à semi-conducteur (S1, S2, S3) pouvant en outre être commandés par des signaux de commande individuels, grâce à quoi,
a) au moins un second modèle (51, 52, 53) de sous-impulsions de commande est créé pour le signal de commande individuel d'au moins un interrupteur de puissance à semi-conducteur (S1, S2, S3) et
b) pour décharger l'interrupteur de puissance à semi-conducteur (S1, S2, S3) dans un état conducteur du montage en parallèle (1), au moins temporairement pendant un nombre d'impulsions de commande de cadre dans le premier modèle (4), un nombre de sous-impulsions de commande en dérivant est choisies dans le second modèle (51, 52, 53),
**caractérisé en ce que**
c) au moins temporairement pendant les impulsions individuelles de commande de cadre plusieurs sous-impulsions de commande sont créées dans le second modèle (51, 52, 53), (fig.2a).

2. Procédé selon la revendication 1,
**caractérisé en ce que**, au moins temporairement pendant les impulsions individuelles de commande de cadre, les sous-impulsions de commande sont émises dans le second modèle (51, 52, 53).

3. Procédé selon l'une quelconque des revendications précédentes,
**caractérisé**,
a) en ce que pendant de courtes impulsions de commande de cadre, dont la largeur d'impulsion se monte au maximum à 100 fois un temps de commutation transitoire de l'interrupteur de puissance à semi-conducteur (S1, S2, S3), le nombre de sous-impulsions de commande n'est pas augmenté par rapport au nombre d'impulsions de commande de cadre et
b) en particulier, en ce qu'une largeur de sous-impulsion de commande est raccourcie par rapport à une largeur d'impulsion de commande de cadre.

4. Procédé d'exploitation d'un montage en parallèle (1) d'interrupteurs de puissance à semi-conducteur (S1, S2, S3), en particulier selon l'une des revendications précédentes, le montage en parallèle (1) présentant une connexion de puissance (2) pour une amenée du courant et une connexion de puissance (3) pour une sortie de courant sur une résistance de charge, le montage en parallèle (1) étant pourvu d'un signal de commande principal avec un premier modèle (4) d'impulsions de commande de cadre pour un courant total (i) à travers le montage en parallèle (1), les interrupteurs de puissance à semi-conducteur (S1, S2, S3) pouvant en outre être commandés par des signaux de commande individuels, grâce à quoi,
a) au moins un second modèle (51, 52, 53) de sous-impulsions de commande est créé pour le signal de commande individuel d'au moins un interrupteur de puissance à semi-conducteur (S1, S2, S3) et
b) pour décharger l'interrupteur de puissance à semi-conducteur (S1, S2, S3) dans un état conducteur du montage en parallèle (1), au moins temporairement pendant un nombre d'impulsions de commande de cadre dans le premier modèle (4), un nombre de sous-impulsions de commande en dérivant étant choisi dans le second modèle (51, 52, 53),
**caractérisé en ce que**
c) au moins deux interrupteurs de puissance à semi-conducteur (S1, S2, S3) sont commandés avec les sous-impulsions de commande, qui complètent l'un l'autre respectivement une impulsion de commande de cadre (fig. 2a).

5. Procédé selon l'une des revendications précédentes,
**caractérisé en ce qu'**au moins deux interrupteurs de puissance à semi-conducteur (S1, S2, S3) sont commandés selon le second modèle (51, 52, 53), qui complètent l'un l'autre le premier modèle (4).

6. Procédé selon l'une des revendications précédentes,
**caractérisé en ce que**
a) on fait varier deux fois d'au moins un facteur, une amplitude stationnaire de courant de charge partiel (i1, i2, i3) au moyen de l'interrupteur de puissance à semi-conducteur (S1, S2, S3) par les sous-impulsions de commande et/ou
b) l'interrupteur de puissance à semi-conducteur (S1, S2, S3) est commuté, par les sous-impulsions de commande, entre un état conducteur et un état sensiblement non conducteur.

7. Procédé selon l'une des revendications précédentes, **caractérisé en ce que**
a) un nombre de sous-impulsions de commande du second modèle (51, 52, 53) est réglé en fonction d'une charge de l'interrupteur de puissance à semi-conducteur associé (S1, S2, S3) du montage parallèle (1) et/ou
b) un nombre de sous-impulsions de commande du second modèle (51, 52, 53) est réglé en fonction d'une largeur d'impulsion des impulsions de commande de cadre et
c) en particulier, **en ce que** un temps de commutation total du second modèle (51, 52, 53) est diminué proportionnellement à la charge de l'interrupteur de puissance à semi-conducteur associé (S1, S2, S3).

8. Procédé selon la revendication 7,
**caractérisé en ce que**
a) une valeur réelle de charge de l'interrupteur de puissance à semi-conducteur (S1, S2, S3)est mesurée et, lors du dépassement d'une valeur théorique de charge, un nombre de sous-impulsions de commande par impulsion de commande de cadre est augmenté ou diminué et
b) en particulier, **en ce que** la valeur réelle et la valeur théorique de charge est une température de l'interrupteur de puissance à semi-conducteur (S1, S2, S3), un courant de collecteur ou de cathode à travers l'interrupteur de puissance à semi-conducteur (S1, S2, S3) ou une valeur moyenne sur une courte durée de ces grandeurs.

9. Procédé selon l'une des revendications 7-8, **caractérisé en ce que**
pour une symétrie thermique du montage en parallèle (1), un nombre de sous-impulsions de commande de tous les seconds modèles (51, 52, 53) est réglé de manière simultanée par un réglage d'équilibre (6).

10. Procédé d'exploitation d'un montage en parallèle (1) d'interrupteurs de puissance à semi-conducteur (S1, S2, S3), le montage en parallèle (1) présentant une connexion de puissance (2) pour une amenée du courant et une connexion de puissance (3) pour une sortie de courant sur une résistance de charge, le montage en parallèle (1) étant pourvu d'un signal de commande principal avec un premier modèle (4) d'impulsions de commande de cadre pour un courant total (i) à travers le montage en parallèle (1), les interrupteurs de puissance à semi-conducteur (S1, S2, S3) pouvant en outre être commandés par des signaux de commande individuels, grâce à quoi,
a) au moins un second modèle (51, 52, 53) de sous-impulsions de commande est créé pour le signal de commande individuel d'au moins un interrupteur de puissance à semi-conducteur (S1, S2, S3) et
b) pour décharger l'interrupteur de puissance à semi-conducteur (S1, S2, S3) dans un état conducteur du montage en parallèle (1), au moins temporairement pendant un nombre d'impulsions de commande de cadre dans le premier modèle (4), un nombre de sous-impulsions de commande en dérivant est choisi dans le second modèle (51, 52, 53),
c) pour obtenir des fréquences de base élevées du courant total (i), un premier modèle avec N impulsions de commande de cadre est réparti sur N seconds modèles (51, 52, 53) avec respectivement une sous-impulsion de commande,
**caractérisé en ce que**
d) pour les premiers modèles (4) successifs, est entreprise une attribution aléatoire des N seconds modèles (51, 52, 53) aux N interrupteurs de puissance à semi-conducteur (S1, S2, S3) du montage en parallèle (1).

11. Procédé selon la revendication 10,
**caractérisé en ce que**, pour les premiers modèles (4) successifs, est entreprise une attribution, statistiquement répartie équitablement, des N seconds modèles (51, 52, 53) aux N interrupteurs de puissance à semi-conducteur (S1, S2, S3) du montage en parallèle (1).

12. Procédé selon l'une des revendications précédentes,
**caractérisé en ce que**
a) le montage en parallèle (1) est un composant d'un module de commutation, en particulier d'une branche d'un demi-pont, d'un onduleur, pour la traction, le transport de courant continu à haute tension, un radio émetteur, le chauffage inductif ou le soudage inductif et/ou
b) les interrupteurs de puissance à semi-conducteur (S1, S2, S3) sont des BJTs, IGBTs, MOSFETs, thyristors, GTOs, MCTs ou une combinaison de ces éléments de construction et en particulier ne présentent pas ou de manière nuisible des sorties de puissance à amplitude réglable.
